# EUROPEAN PATENT APPLICATION

(11) **EP 2 186 921 A1**
(43) Date of publication of application: **19.05.2010**
(21) Application number: 09007805.6
(22) Date of filing: 13.06.2009
(51) Int. Cl.: C23C 16/27, C23C 16/44

(54) **Filament arrangement for hot wire chemical vapour deposition**

(30) Priority: 13.11.2008 EP 08019822
(71) Applicant: Echerkon Technologies Ltd., Crawley West Sussex RH11 8AD (GB)
(72) Inventor: Tarazona Labrador, Antulio, West Sussex RH11 ODN (GB)
(74) Representative: Twelmeier Mommer & Partner

(57) **Abstract**

The invention refers to a filament arrangement for hot wire chemical vapour deposition of semiconductor or dielectric layers, comprising a catalytic filament (4) for catalytic conversion of precursor molecules, and two chemically inert filaments (3) which are each joined in an electrically conductive way to opposite ends of the catalytic filament. The invention also refers to a method for depositing semiconductor or dielectric layers by hot wire chemical vapour deposition on a substrate, comprising heating a catalytic filament (4) by means of an electric current and exposing the catalytic filament (4) to an atmosphere comprising precursor molecules which are thereby catalytically converted. According to the invention the electric current is applied to the catalytic filament (4) via chemically inert filaments (3) which are each joined in an electrically conductive way to opposite ends of the catalytic filament (4).

## Description

The invention refers to a filament arrangement for hot wire chemical vapour deposition of semiconductor layers, especially silicon layers, or dielectric layers. The invention also refers to an improved method for deposition of silcon layers by hot wire chemical vapour deposition of such layers.

In the so called hot wire chemical vapour deposition (HWCVD), also know as CAT-CVD or Hot Filament CVD, heated catalytic filaments made of catalysts like tungsten, tantalum or molybdenum are used to catalytically convert precursor molecules into radicals which form semiconductor or dielectric layers. One of the most widely researched precursor molecules are silane molecules used to grow silicon layers. Other possible precursor molecules are germanium hydrides which may be used to deposit germanium layers, carbon hydrides for deposition of diamond like layers or mixtures of ammonia and silane molecules for silcon nitride layers.

HWCVD promises very high deposition rates of thin film layers and is easily scale-able up to very large areas. However, catalytic filaments tend to age rather quickly due to formation of silicides or carbides, depending on the type of precursor molecules employed. Thereby filaments become increasingly brittle which eventually leads to breakage.

The object of the present invention is therefore to show a way to improve the lifetime of catalytic filaments used in HWCVD, especially for the deposition of silicon layers.

This object is achieved by a filament arrangement according to claim 1 as well as a method according to claim 13.

According to the present invention a catalytic filament is connected electrically in series to two chemically inert filaments by joining an end of each chemically inert filament to an end of the catalytic filament. This leads to a significant increase in the lifetime of the catalytic filament.

Preferably the catalytic filament is made out of tungsten, tantalum filament or molybdenum. The filaments may be made of technically pure tungsten, tantalum or molybdenum, respectively. However, catalytic filaments may also be made of alloys or intermetallic compounds. Preferably the catalytic filament consists predominantly of tungsten, tantalum, molybdenum or niobium.

The chemically inert filaments are preferably made of a noble metal or alloy. Platinum group metals like rhenium, iridium or platinum are especially well suited as they have a rather high melting point.

The chemically inert filaments may be joined to the catalytic filament by welding. It is also possible to join the filaments mechanically, e. g. by twisting or clamping.

A suitable mechanical joint may comprise a nut, and a bolt for clamping one of the chemically inert filaments to each end of the catalytic filament. The nut, bolt and any other parts, e.g. a washer, of such a joint may be made of any of the materials which can be used for a catalytic filament or the chemically inert filament. For example, a mechanical joint may be provided by parts made of a platinum group metal or of a refractory metal like molybdenum.

Another example for a suitable mechanical joint is a tube into which an end of the catalytic filament and an end of one of the chemically inert filaments are stuck. The tube may be crimped to create a clamping force holding the filaments in the tube. It is possible to stick the catalytic filament and one of the chemically inert filaments into the same end of the tube to create a mechanical joint. Preferably, the catalytic filament and one of the chemically inert filaments are stuck into opposite ends of the tube. The tube may be made of any of the materials which can be used for a catalytic filament or the chemically inert filament. For example, a mechanical joint may be provided by parts made of a platinum group metal or of a refractory metal like molybdenum. The tube may be swaged to facilitate crimping.

When a filament arrangement according to the invention is used for HWCVD, the chemically inert filaments are connected to the terminals of a voltage source. The resulting electrical current heats the chemically inert filaments as well as the catalytic filament in between. Therefore a rather uniform temperature, without cold spots, can be achieved along the entire length of the catalytic filament even at temperatures above 2000 °C. This can be used to suppress silicide and carbide formation efficiently.

Irreversible silicide formation is temperature dependent and most pronounced at temperatures significantly between 1600 °C 1900 °C. In prior art the ends of a catalytic filament have cold spots, at temperatures where irreversible silicide or carbide formation takes place, due to the contact to terminals, which has a high thermal mass, of a voltage source and therefore have a lower temperature. This can be avoided by using a filament arrangement according to the present invention because only the chemically inert filaments will have a high temperature gradient due to being in contact to the electrical current source, at much lower temperature.

Preferably the chemically inert filaments have an electrical resistance per unit of length which is at least 80% of the electrical resistance of the catalytic filament per unit of length. Thereby the flow of heat from the ends of the catalytic filament to the chemically inert filament can be minimized which avoids any cold spots of the ends of the catalytic filament. As refractory metals like tungsten and molybdenum have an electrical conductivity which is higher that the conductivity of platinum group metals like platinum, rhodium and rhenium, this can be most easily achieved by choosing the diameter of the chemically inert filaments to be equal to the diameter of the catalytic filament.

In a method according to the invention the precursor molecules are preferably silane molecules.

Further aspects and advantages of the present invention are explained in the following with respect to the enclosed figures illustrating a preferred embodiments of the invention. Corresponding parts of different embodiments are marked with identical reference numerals.
- Figure 1:: shows schematically an exemplary embodiment of a filament arrangement according to the present invention;
- Figure 2:: shows a detail view of fig. 1;
- Figure 3:: shows schematically another exemplary embodiment of a filament arrangement according to the present invention.

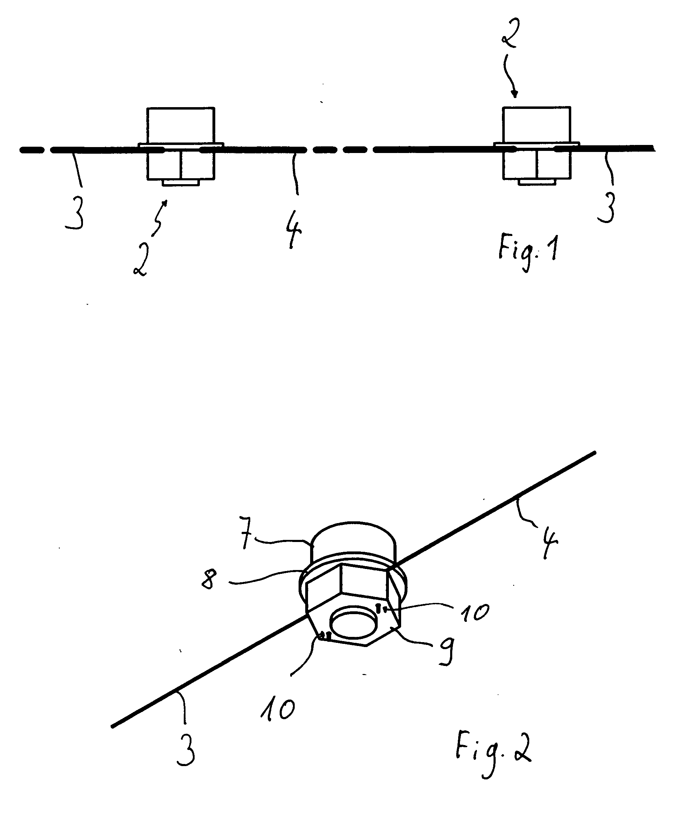

The filament arrangement shown schematically in a cross-section view by figure 1 comprises a catalytic filament 4 for catalytic conversion of precursor molecules like silane, chemically inert filaments 3 and mechanical joints 2 each joining a chemically inert filament 3 in an electrically conductive way to an end of the catalytic filament 4. For HWCVD the chemically inert filaments 3 are each connected to terminals of an electrical power supply to cause electrical heating of the filaments 3, 4 by current flow. In this way the filament arrangement is hanging suspended by the chemically inert filaments 3. It is also possible to suspend the filament arrangement by means of thin ceramic members. As such ceramic pieces or wires have a low thermal mass and low thermal conductivity this will not cause any notable cooling of the filaments.

For deposition of semiconductor films like silicon films or dielectric films, the catalytic filament 4 can be made out of tungsten, tantalum, molybdenum, niobium or an alloy of these metals. Tungsten, tantalum and/or molybdenum may also be alloyed with a noble metal. The chemically inert filament 3 may be made out of rhenium, iridium, platinum or some other noble metal or alloy. The filaments 3, 4 preferably have a diameter of 0.1 mm to 1 mm. The filaments 3, 4 may all have the same diameter. Preferably the diameters of the filaments 3, 4 differ at most by 0.2 mm, especially at most by 0.1 mm.

The mechanical joint 2 is depicted in more detail in figure 2 which is not to scale. The embodiment of the joint 2 comprises a threaded bolt 7, a washer 8 and nut 9. All components should be able to withstand temperatures in excess of 2000°C and may be made for example of a refractory metal like molybdenum or a platinum group metal like for example platinum, rhenium or iridium. The mechanical joint 2 has a low thermal mass and is therefore quickly heated to the same temperature as the filaments 3, 4.

The nut 9 has two boreholes 10 extending between its ends. An end of the catalytic wire 4 and an end of a chemically inert wire 3 are each stuck into one of these boreholes 10. Threaded bolt 7 and nut 9 are then tightened to clamp the filaments 3, 4 against the washer 8.

In order to deposit silicon layers onto a substrate, at least one filament arrangement is placed in a chamber which is then evacuated below atmospheric pressure. By installing several such filament arrangements in the chamber deposition rates can be favourably increased. The filaments 3, 4 are then heated up to temperatures above 1900°C by passing an electric current through them. Gas precursors or vapours containing silane molecules are then introduced in the chamber and broken down by the hot catalytic filament 4 which thereby converts silane molecules catalytically into radicals.

The term silane molecules encompasses mono-, di- and tri-silane molecules as well as any other hydrides of silicon used as precursors to deposit thin films of silicon.

Other gases or precursors can be added to modify the characteristics of the film, e.g. doping. For example ammonia may be added to grow silicon nitride films.

For deposition of other semiconductor layers, for example germanium or silcon/germanium films, germanium hydride molecules have to be used as precursors. Likewise carbon hydride molecules may be used to grow diamond like film by HWCVD.

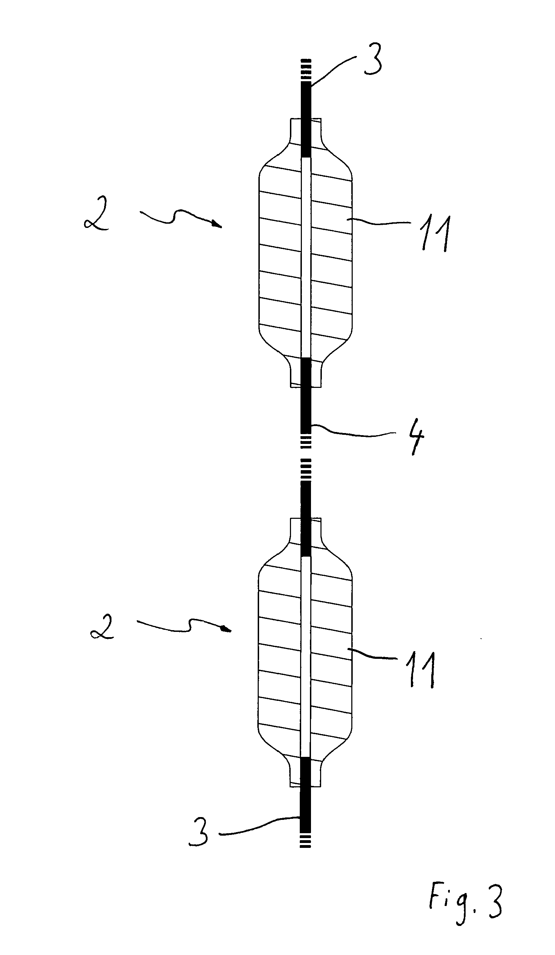

Figure 3 shows a second embodiment of a filament arrangement for HWCVD. This filament arrangement differs from the previously discussed embodiment only with respect to the mechanical joints 2 joining an end of the catalytic filament 4 to a chemically inert filament 3 in an electrically conductive way.

The mechanical joints 2 each comprise a tube 11 which holds at one end a chemically inert filament 3 and at its other end the catalytic filament 4. The chemically inert filament 3 and the catalytic filament 4 are each stuck into an end of the tube 11 and held therein by clamping forces, preferably caused by crimping.

The tube 11 is made of an electrically conductive material able to withstand elevated temperatures necessary for HWCVD without losing the grip of neither the inert filament 3 nor the catalytic filament 4. Preferably, the tube 11 is made of metal. For example, the tube 11 may be made of a refractory metal, like tantalum, molybdenum, niobium or tungsten, or a platinum group metal like for example platinum, rhenium or iridium.

The wall thickness of the tube 11 is preferably at least twice the diameter of the catalytic filament 4. If the tube is made of a metal that reacts with precursor molecules, for example by silicide formation like tantalum, molybdenum, tungsten, the tube 11 is then able last for an extended period of time before it becomes to brittle to hold the filaments 3, 4.

The tube 11 may be swaged at its ends to facilitate crimping.

## Claims

1. Filament arrangement for hot wire chemical vapour deposition of semiconductor or dielectric layers, comprising
a catalytic filament (4) for catalytic conversion of precursor molecules, and
two chemically inert filaments (3) which are each joined in an electrically conductive way to opposite ends of the catalytic filament.

2. Filament arrangement according to claim 1, **characterized in that** the catalytic filament (4) consists predominantly of tungsten, tantalum and/or molybdenum.

3. Filament arrangement according to any of the preceding claims, **characterized in that** the chemically inert filaments (3) are made out of a noble metal or alloy.

4. Filament arrangement according to any of the preceding claims, **characterized in that** the chemically inert filaments (3) consist predominantly of one or several platinum group metals.

5. Filament arrangement according to any of the preceding claims, **characterized in that** the chemically inert filaments (3) are made out of rhenium, iridium or platinum.

6. Filament arrangement according to any of the preceding claims, **characterized in that** the catalytic filament (4) is joined to the chemically inert filaments (3) by welding.

7. Filament arrangement according to any of the preceding claims, **characterized in that** chemically inert filaments (3) are each joined to the catalytical filament (4) by a mechanical joint (2).

8. Filament arrangement according to claim 7, **characterized in that** the joint (2) comprises a nut (9) and a threaded bolt (7) for clamping one of the chemically inert filaments (3) and the catalytic filament (4).

9. Filament arrangement according to claim 7, **characterized in that** the joint (2) comprises a tube (11) into which an end of the catalytic filament (4) and an end of one of the chemically inert filaments (3) are stuck.

10. Filament arrangement according to claim 9, **characterized in that** the tube (11) is crimped.

11. Filament arrangement according to any of the preceding claims, **characterized in that** the chemically inert filaments (3) have an electrical resistance per unit length which is at least 80% of the electrical resistance of the catalytic filament (4) per unit length.

12. Filament arrangement according to any of the preceding claims, **characterized in that** the chemically inert filaments (3) have an electrical resistance per unit length which is at least as large as the electrical resistance of the catalytic filament (4) per unit length, preferably at least one and a half times as large.

13. Method for depositing semiconductor or dielectric layers by hot wire chemical vapour deposition on a substrate, comprising
heating a catalytic filament (4) by means of an electric current and exposing the catalytic filament (4) to an atmosphere comprising precursor molecules which are thereby catalytically converted,
**characterized in that** the electric current is applied to the catalytic filament (4) via chemically inert filaments (3) which are each joined in an electrically conductive way to opposite ends of the catalytic filament (4).

14. Method according to claim 13, **characterized in that** the filament arrangement comprising the catalytic filament (4) and the chemically inert filaments (3) is hanging suspended by the chemically inert filaments (3).

15. Method according to claim 13, **characterized in that** the filament arrangement comprising the catalytic filament (4) and the chemically inert filaments (3) is hanging suspended by a ceramic member.
